# EUROPEAN PATENT APPLICATION

(11) **EP 4 632 745 A1**
(43) Date of publication of application: **15.10.2025**
(21) Application number: 23901044.0
(22) Date of filing: 05.12.2023
(51) Int. Cl.: G11C 17/18, G11C 17/16

(54) **TIMING CONTROLLER COMPRISING EFUSE BLOCK, AND SETTING VALUE SELECTION METHOD**

(30) Priority: 05.12.2022 KR 20220167637
(71) Applicant: LX Semicon Co., Ltd., Daejeon 34027 (KR)
(72) Inventor: BAEK, Jin Joo, Daejeon 34027 (KR)
(74) Representative: Ter Meer Steinmeister & Partner
(86) International application number: PCT/KR2023/019847
(87) International publication number: WO 2024/123025

(57) **Abstract**

The present invention proposes a timing controller comprising an eFuse block for generating a final setting value determined according to whether fusing or trimming is performed, and a method for selecting the final setting value. The timing controller comprising the eFuse block comprises: an analog signal transmission and reception unit which comprises a low dropout regulator, and receives a final setting value to adjust an operating condition of a function block installed therein; and an efuse block which selects the final setting value corresponding to a voltage level of an LDO output terminal, the final setting value being determined according to whether a fusing or trimming process for adjusting the voltage level of the LDO output terminal is performed.

## Description

### [Technical field]

The present invention relates to a timing controller, and more particularly, to a timing controller including an efuse block that generates a final setting value determined by whether fusing or trimming is performed according to a setting value selection method.

### [Background art]

Since the process of producing a semiconductor integrated circuit is carried out through various and complex process conditions and multiple processing steps, the electrical characteristics of the integrated circuit after the process may have a certain difference from the designed one. Such differences are caused by matching errors of the same pattern due to etching tolerance in the etching step during the process and unexpected transitions in the electrical characteristic values of the element due to high-temperature processing.

A low dropout regulator (LDO) generates an output power supply with a voltage level lower than that of the input power supply, and provides an output power supply with a stable voltage level even if the voltage level of the input power supply is unstable.

The voltage level of the output voltage of the LDO is determined by using the ratio of the resistance values of two resistors connected in series to the output terminal of the LDO. For the reason described above, the LDO in the wafer state after the process generates a voltage level with a certain error.

In order to improve this error, a method is used in which each of the two resistors is manufactured with a structure in which multiple resistors are connected in parallel, and then the resistance value of some of the resistors connected in parallel in the wafer state is increased by blocking the parallel connection of the resistors. Blocking the parallel connection is called fusing or trimming. Fusing or trimming is named so because it melts or cuts the part that connects the resistor to the other resistor. Depending on the embodiment, a method of blocking the parallel connection using the opening and closing operation of a switch is also used.

Since the fusing or trimming process involves time and cost, the wafer manufacturer wants to avoid the fusion or trimming process unless it is absolutely necessary. In addition, even for the same product, depending on the customer and whether it is a prototype or mass production, some products require trimming in the wafer state, while others are packaged and shipped without trimming.

The electrical characteristics and characteristics of the packaged product can be adjusted by the customer or the manufacturer's quality control team. In this case, the customer or the manufacturer's quality control team must be notified of whether the packaged chip is trimmed so that it can be utilized.

In order to notify the trimming status, the trimming information of the chip must be managed separately, and there is a disadvantage in that problems may occur if incorrect information is notified due to management errors, etc.

### [Detailed Description of the Invention]

### [Technical Problem]

The technical problem that the present invention seeks to solve is to provide an efuse block that generates a final setting value determined depending on whether fusing or trimming is performed.

Another technical problem that the present invention seeks to solve is to provide a timing controller including an efuse block that generates a final setting value determined depending on whether fusing or trimming is performed.

Another technical problem that the present invention seeks to solve is to provide a method for selecting a final setting value determined depending on whether fusing or trimming is performed.

### [Technical Solution]

The efuse block according to the present invention for achieving the above technical problem selects a final setting value corresponding to the voltage level of the LDO output terminal determined depending on whether a fusing or trimming process is performed to adjust the voltage level of the LDO output terminal.

A timing controller according to the present invention for achieving the above other technical task includes an efuse block for selecting a final setting value corresponding to a voltage level of an LDO output terminal, which is determined based on whether a fusing or trimming process is performed to adjust the voltage level of an LDO output terminal and a low dropout regulator (hereinafter referred to as LDO).

A setting value selection method according to the present invention for achieving the above other technical task includes a step of assembling a chip that has completed a semiconductor manufacturing process, a step of determining whether fusing or trimming has been performed on a target portion before assembling, a step of determining whether to use an optimal setting value corresponding to the result of performing fusing or trimming, and a step of selecting a final setting value based on the determination result obtained through the two determination steps.

### [Effect of the invention]

The timing controller including the efuse block according to the present invention and the setting value selection method described above can use the optimal setting value for materials that have been normally fusing or trimming and can use the initial setting value for materials that have not been fusing or trimming, even if the final selection value (val_sel) is always set to a specific value without directly checking whether fusing or trimming is in progress, so there is an advantage in that only one code can be used without the need for version management for fusing or trimming progress.

### [Brief description of the drawings]

FIG. 1 is an embodiment of a timing controller including an efuse block according to the present invention.
FIG. 2 is an embodiment of an efuse block.
FIG. 3 illustrates an example of efuse data.
FIG. 4 is an embodiment of a setting value selection method according to the present invention.
FIG. 5 compares the distribution when the voltage level of the output terminal of the LDO is designed to be 0.9 V, when the produced integrated circuit is not processed and when it is processed.

### [Best mode]

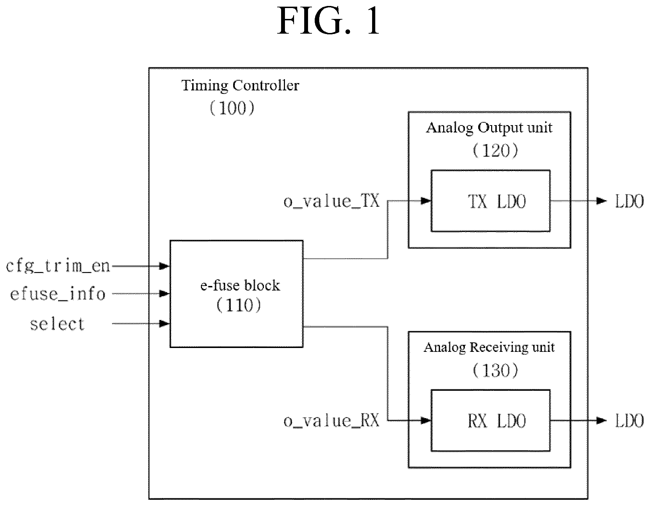

FIG. 1 is an embodiment of a timing controller including an efuse block according to the present invention.

Referring to FIG. 1, a timing controller (100, hereinafter referred to as timing controller) including an efuse block according to the present invention includes an efuse block 110, an analog signal output unit 120, and an analog signal receiving unit 130. The analog signal output unit 120 and the analog signal receiving unit 130 may be integrated to be referred to as an analog transceiver.

The efuse block 110 generates final setting information (o_value) related to the voltage level of the output terminal of the LDO included in the analog signal output unit 120 and the analog signal receiving unit 130.

The analog signal output unit 120 and the analog signal receiving unit 130 optimize the operation of the internal circuit in response to the final setting information (o_value).

Although the specific circuit of the LDO included in the analog signal output unit 120 and the analog signal receiving unit 130 illustrated in FIG. 1 is not illustrated, the specific circuit of the LDO is not only not the subject of the present invention, but also a person skilled in the art can easily derive the specific circuit, so it is not illustrated or described in detail here.

In general, two voltage distribution resistors that determine the output voltage of the LDO are installed at the output terminal of the LDO. In addition, the two distribution resistors are not single resistors but each form a structure in which multiple resistors are connected in parallel, and as will be described later, it is possible to adjust the output voltage of the LDO through fusing or trimming in the wafer state before assembly.

This is a technology regarding measures when the analog signal output unit 120 and the analog signal receiving unit 130 illustrated in FIG. 1 include both examples of performing fusing or trimming in the wafer state and examples of assembling without performing fusing or trimming.

The specific circuit (not shown) installed in the analog signal output unit 120 and the analog signal receiving unit 130 will predict the voltage level of the output terminal of the LDO installed in each by using the final setting value (o_value) generated in the efuse block 110 and transmitted to the analog signal output unit 120 and the analog signal receiving unit 130, and will optimize the operating conditions of the function blocks installed in each by adjusting or setting them to utilize this. However, this part is not a technology proposed in the present invention, and since a technician with general knowledge in this field can easily derive it, it will not be described in detail here.

In the past, since the information corresponding to the final setting value (o_value) was manually modified by the worker or the existing set value was not modified at all, there was a disadvantage in that the deviation of the electrical characteristics of the assembled integrated circuit was considerably large.

As will be described later, it can be seen that the deviation of the electrical characteristics of the integrated circuit to which the method proposed in the present invention is applied is considerably smaller than in the past.

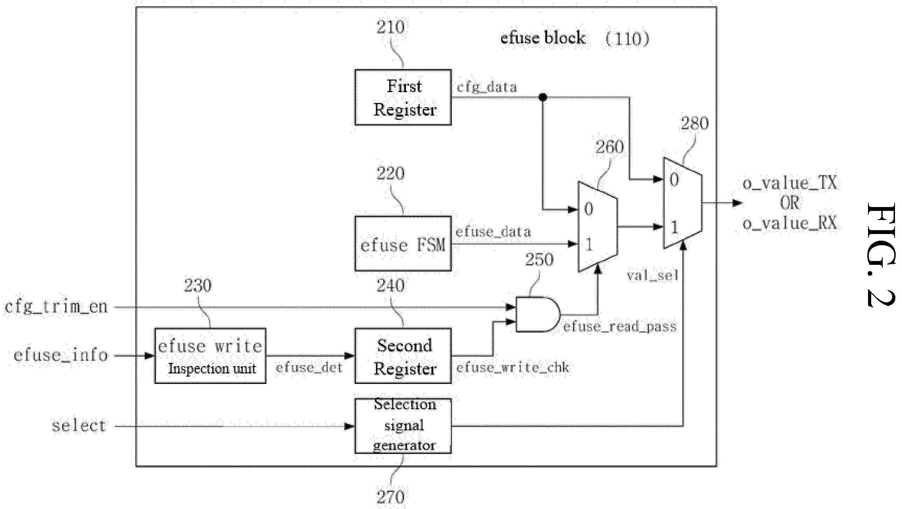

FIG. 2 is an example of an efuse block.

Referring to FIG. 2, the efuse block 110 includes a first register 210, an efuse FSM 220, an efuse write inspection unit 230, a second register 240, an AND gate 250, a first multiplexer 260, a selection signal generator 270, and a second multiplexer 280.

The first register 210 stores data set during design of the voltage level of the output terminal of the LDO included in the analog signal output unit 120 and the analog signal receiving unit 130, that is, an initial setting value (cfg_data).

The efuse FSM 220 generates optimal data, that is, optimal setting value (efuse_data), of the voltage level of the output terminal of the LDO included in the analog signal output unit 120 and the analog signal receiving unit 130. The optimal setting value (efuse_data) is a value determined after performing fusing or trimming on the voltage distribution resistor installed in the analog signal output unit 120 and the analog signal receiving unit 130 in the wafer state. The efuse FSM 220 uses a finite state machine, and a finite state machine means a computational model composed of a finite number of states and transitions between states, and maintains one state and changes the state according to the conditions under which the state is switched.

Since the initial setting value (efg_data) and the optimal setting value (efuse_data) have information about the voltage level of the output terminal of the LDO, the analog signal output unit 120 and the analog signal receiving unit 130 can use them to optimize the operation of the internal function block according to the setting value they receive.

The efuse write inspection unit 230 receives efuse information (efuse_info) that can determine whether fusing or trimming has been performed in the wafer state, and generates a judgment result signal (efuse_det) if it determines that fusing or trimming has been performed.

The second register 240 stores the judgment result signal (efuse_det) received from the efuse write inspection unit 230 and outputs it as the first information (efuse_write_chk). That is, the first information will include information about whether fusing or trimming has been performed.

The AND gate 250 performs AND on the logic value of the second information (cfg_trim_en) that has information on whether to use the optimal setting value (efuse_data) output from the efuse FSM 220 and the logic value of the first information (efuse_write_chk) to generate the third information (efuse_read_pass). For convenience of explanation, it is assumed that the third information (efuse_read_pass) is activated or has a logic high value when fusing or trimming is performed and it is determined that the optimal setting value (efuse_data) is used at the same time.

The first multiplexer 260 selects and outputs one of the initial setting value (efg_data) and the optimal setting value (efuse_data) according to the logic value of the third information (efuse_read_pass). For example, if the logic value of the third information (efuse_read_pass) is logic high (1), the optimal setting value (efuse_data) is selected and output, and conversely, if the logic value is logic low (0), the initial setting value (efg_data) is selected and output.

The selection signal generator 270 generates a setting value selection signal (val_sel) having a constant logic value unless a forced selection control signal (select) is applied from the outside.

The second multiplexer 280 selects one of the initial setting value (efg_data) and the output of the first multiplexer 260 according to the logic value of the setting value selection signal (val_sel) and outputs it as the final setting value (o_value). The final setting value (o_value) can be divided into a value (o_value_TX) transmitted to the analog signal output unit 120 and a value (o_value_RX) transmitted to the analog signal receiving unit 130.

In the present invention, unless a forced selection control signal (select) is applied from the outside, the logic value of the setting value selection signal (val_sel) output from the selection signal generator 270 is maintained at logic high, and when the logic value of the setting value selection signal (val_sel) is logic high (1), the second multiplexer 280 selects and outputs the output of the first multiplexer 260 as the final setting value (o_value).

As described above, the first multiplexer 260 selects and outputs one of the optimal setting value (efuse_data), which is the setting value when fusing or trimming is performed, and the initial setting value (efg_data), which is the setting value when fusing or trimming is not performed. Therefore, the final setting value (o_value) will select one of the initial setting value (efg_data) and the optimal setting value (efuse_data). However, if a user or operator wants to force the final setting value (o_ value) to the initial setting value (efg_data), the forced selection control signal (select) can be activated so that the logic value of the setting value selection signal (val_sel) becomes logic low (0).

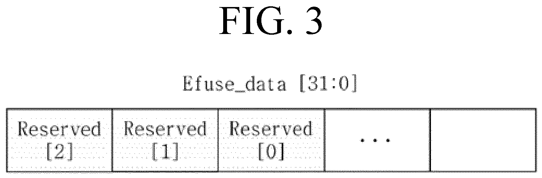

FIG. 3 illustrates an example of efuse data.

Referring to FIG. 3, efuse data, i.e., optimal setting value (efuse_data), can be implemented as 32 bits [31:0], but the optimal setting value (efuse_data) may have different specifications provided for each process.

Depending on the embodiment, some of the data representing the optimal setting value (efuse_data) may be set as reserved data bits (Reserved [0] ~ Reserved [2]), and the values of the bits set as reserved data bits may be compared with pre-stored values, and if they match, it may be determined that fusing or trimming has been performed.

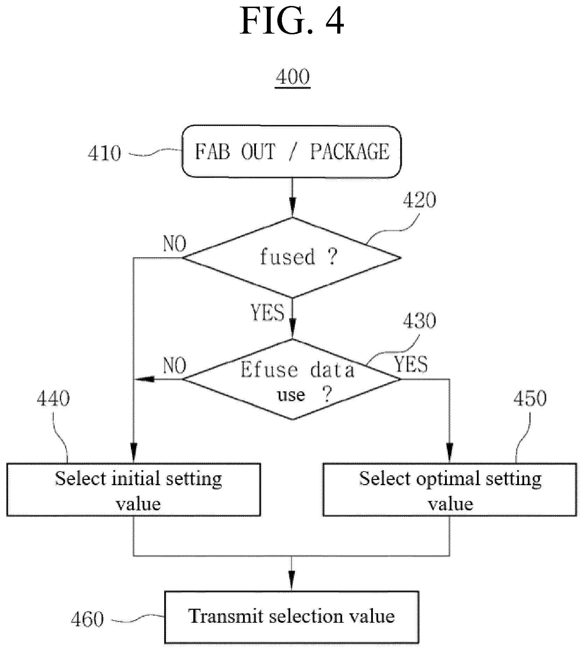

FIG. 4 is an embodiment of a setting value selection method according to the present invention.

Referring to FIG. 4, the setting value selection method 400 according to the present invention includes a step of assembling a chip that has completed a semiconductor manufacturing process 410, a step of determining whether fusing or trimming has been performed on a target portion before assembling 420, a step of determining whether to use an optimal setting value corresponding to the result of performing fusing or trimming 430, and a step of selecting an initial setting value 440, a step of selecting an optimal setting value 450, and a step of transmitting a selected value 460 based on the result of the above steps.

The step 440 of selecting the initial setting value selects the initial setting value (cfg_data) as the final setting value (o_value) when it is determined that fusing or trimming was not performed (420, NO) based on the determination result in the step 420 of determining whether fusing or trimming was performed on the target portion before assembly, or when it is determined not to use the optimal setting value corresponding to the result of fusing or trimming (430, NO) in the step 430.

The step 450 of selecting the optimal setting value selects the optimal setting value (efuse_data) as the final setting value (o_value) when it is determined (420, YES) that fusing or trimming has been performed on the target portion as a result of the determination in the step 420 of determining whether fusing or trimming has been performed before assembly and when it is determined (430, YES) that the optimal setting value corresponding to the result of fusing or trimming will be used.

The step 460 of transmitting the selected value transmits the setting values selected in the step 440 of selecting the initial setting value and the step 450 of selecting the optimal setting value to the analog signal output unit 120 and the analog signal receiving unit 130, respectively.

The setting value selection method 400 according to the present invention illustrated in FIG. 4 is optimally performed in the timing controller 100 including the efuse block illustrated in FIG. 1, but an embodiment in which it is implemented using separate hardware or a processor is also possible.

Although not described in detail above, the efuse write inspection unit 230 and the selection signal generator 270 can be implemented as a processor that processes signals.

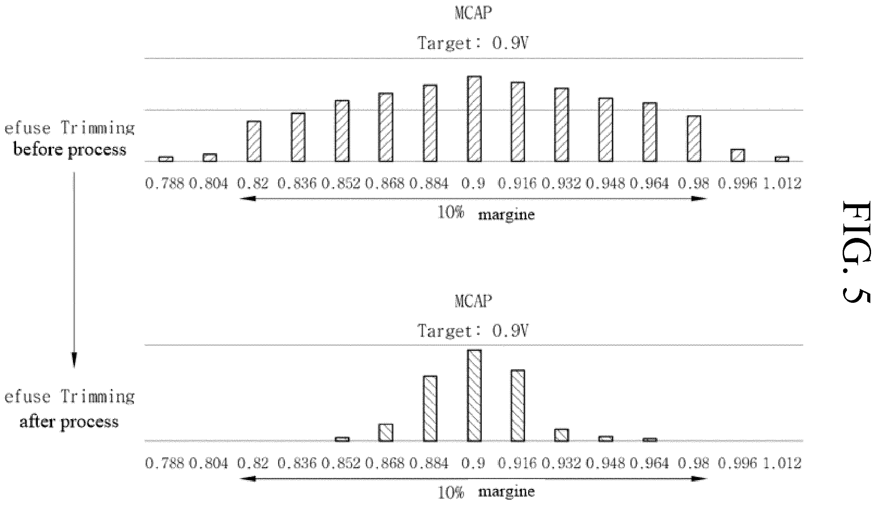

FIG. 5 compares the distribution when the produced integrated circuit is not processed and when it is processed when the voltage level of the output terminal of the LDO is designed to be 0.9 V.

Referring to FIG. 5, it can be seen that the distribution between 0.82 V and 0.98 V, which is a 10% margin range of the designed target voltage of 0.9 V, has a relatively small deviation when the produced integrated circuit is processed (after efuse trimming) compared to when it is not processed (before efuse trimming).

In other words, when the produced integrated circuit is processed (after efuse trimming), it is distributed around the value center of the target electrical characteristic, so it is clear that the yield and electrical characteristics of the product are superior compared to when it is not processed (before efuse trimming).

The above-described present invention can be implemented as a computer-readable code on a medium in which a program is recorded. The computer-readable medium includes all kinds of recording devices in which data that can be read by a computer system is stored. Examples of computer-readable media include Hard Disk Drive (HDD), Solid State Disk (SSD), Silicon Disk Drive (SDD), ROM, RAM, CD-ROM, magnetic tape, floppy disk, and optical data storage devices.

### [Industrial Applicability]

The timing controller including the efuse block and the setting value selection method can be used by always setting the final selection value (val_sel) to a specific value without directly checking whether the fusing or trimming is in progress, so that materials that have been fusing or trimming normally can receive and use the optimal setting value, and materials that have not been fusing or trimming can receive and use the initial setting value, so that only one code can be used without the need for version management for the fusing or trimming progress, and thus has industrial applicability.

## Claims

1. An efuse block for selecting a final setting value corresponding to a voltage level of a Low Dropout Regulator, (LDO) output terminal, which is determined according to whether a fusing or trimming process is performed to adjust the voltage level of the LDO output terminal.

2. The efuse block according to claim 1, wherein the efuse block includes:
a first register configured to store an initial setting value corresponding to the voltage level of the LDO output terminal included in an analog signal transceiver set when design;
an efuse FSM configured to generate an optimal setting value, which is optimal data of the voltage level of the LDO output terminal included in the analog signal transceiver;
a second register configured to store first information on whether the fusing or trimming is performed;
an AND gate configured to generate third information by logically multiplying a logic value of second information on whether to use the optimal setting value output from the efuse FSM and a logic value of the first information; and
a first multiplexer configured to select one of the initial setting value and the optimal setting value according to a logic value of the third information,
wherein thhe optimal setting value is a value determined after performing the fusing or trimming on a voltage distribution resistor installed in the LDO of the analog signal transceiver in a wafer state.

3. The efuse block according to claim 2, wherein the efuse block further includes an efuse write inspection unit configured to receive efuse information capable of determining whether the fusing or trimming has been performed in the wafer state and generate a determination result signal when it is determined that the fusing or trimming has been performed,
wherein the second register is configured to store the determination result signal received from the efuse write inspection unit and output the determination result signal as the first information.

4. The efuse block according to claim 2, wherein the first multiplexer is configured to:
select and output the optimal setting value when the logic value of the third information is logic high, and
select and output the initial setting value when the logic value of the third information is logic low.

5. The efuse block according to claim 2, wheren the efuse block further includes a selection signal generator configured to generate a setting value selection signal to change the logic value in response to a forced selection control signal applied from an outside.

6. The efuse block according to claim 5, wherein the efuse block further includes a second multiplexer configured to select and output one of the initial setting value and the output of the first multiplexer according to the logic value of the setting value selection signal as the final setting value,
wherein the setting value selection signal has a value that causes the second multiplexer to select and output the output signal of the first multiplexer before the forced selection control signal is applied.

7. A timing controller comprising:
a low dropout regulator (LDO); and
an efuse block configured to select a final setting value corresponding to a voltage level of a LDO output terminal, which is determined according to whether a fusing or trimming process for adjusting the voltage level of the LDO output terminal is performed.

8. A method for selecting a setting value, comprising:
assembling a chip that has completed a semiconductor manufacturing process;
determining whether a fusing or trimming has been performed on a target portion before assembly;
determining whether to use an optimal setting value corresponding to a result of performing the fusing or trimming; and
selecting a final setting value according to the determination result obtained through the two determination steps.

9. The method according to claim 8, wherein selecting the final setting value includes:
selecting the initial setting value as the final setting value when it is determined that the fusing or trimming has not been performed or when it is determined not to use an optimal setting value corresponding to the result of performing the fusing or trimming; and
selecting the optimal setting value as the final setting value when it is determined that the fusing or trimming has been performed and when it is determined to use an optimal setting value corresponding to the result of performing the fusing or trimming.

10. The method according to claim 9, further comprising:
transmitting the optimal setting value selected in selecting the final setting value to an analog transceiver including an LOD inside,
wherein the analog transceiver is configured to optimize an operating condition of an internal circuit by using the optimal setting value.
